# EUROPEAN PATENT APPLICATION

(11) **EP 4 358 114 A1**
(43) Date of publication of application: **24.04.2024**
(21) Application number: 23190693.4
(22) Date of filing: 09.08.2023
(51) Int. Cl.: H01J 37/32, H01L 21/3065

(54) **APPARATUS AND METHOD FOR REDUCING SUBSTRATE THICKNESS AND SURFACE ROUGHNESS**

(30) Priority: 18.10.2022 GB 202215394
(71) Applicant: SPTS Technologies Limited, Newport Gwent NP18 2TA (GB)
(72) Inventor: Mumford, Roland, Cardiff, CF14 1RF (GB); Day, Matthew Michael, Newport, NP18 2TA (GB)
(74) Representative: Wynne-Jones IP Limited

(57) **Abstract**

An apparatus for thinning and reducing the surface roughness of a substrate, a method for thinning and reducing the surface roughness of a substrate and a method of reducing the thickness of a substrate are provided herein.

## Description

The present invention relates to an apparatus for thinning and reducing the surface roughness of a substrate and a method of thinning and reducing the surface roughness of a substrate. The present invention also relates to a method of thinning a substrate.

### Background

The technical and economic challenges of classical, two-dimensional "Moore's Law" scaling are increasing for advanced technology nodes, for example nodes below 5nm. As a result, greater consideration is being given to three-dimensional heterogeneous integration schemes, where die are attached together in an integrated package to provide improved system performance. In many instances, these 3D schemes require that die are reduced in thickness, or thinned, typically to a thickness of less than 100 µm from the original wafer thickness of approximately 775µm to facilitate integration into a heterogeneous package. For example, average substrate thicknesses of less than 5 µm are being considered for 3D heterogeneous integration schemes. While semiconductor thinning is an established technology, such a reduction in dies thicknesses presents new challenges that must be addressed to make these integration schemes commercially viable.

Conventional thinning of semiconductor wafers after device fabrication is typically achieved by two major processes. Firstly, the thickness of the semiconductor wafer is reduced by grinding the back of the semiconductor wafer (i.e. the side of the wafer that is not processed to form devices) to remove the bulk of the unwanted semiconductor material. Secondly, the semiconductor wafer is then subjected to chemical mechanical polishing (CMP) to remove several microns of material and reduce the surface roughness of, or smooth, the ground wafer. These thinning methods are potentially followed by a wet etch and or plasma etch step for relief of stress within the wafer. Each of these steps typically removes smaller amounts of material and achieves a smoother and or more uniform surface with reduced surface roughness. The variation of thickness across a wafer, or the difference between the thickest and thinnest points of the wafer, is frequently defined in terms of Total Thickness Variation (TTV), while the mean (or average) wafer thickness is specified as Residual Silicon Thickness (RST). However, TTV is determined by the difference between the most prominent, or thickest, point of the substate and the most recessed, or thinnest, point of the substrate. Therefore, TTV can only reflect the extremes of thickness variation, and does not reflect the distribution or spread of the variation in thickness across the substrate. Whilst a low TTV value would be expected to correspond to a low variation in thickness across the whole of the substrate, a high TTV value is not illustrative of the thickness variation of the substrate as a whole. For example, a substrate could have a portion with significant local variation in the thickness of the substrate, such as through large peaks and troughs in the substrate surface, whilst the remainder of the substrate is extremely uniform. Such a substrate would have a high TTV value, but this does not represent the distribution of the variation in thickness across the substrate.

In fusion or hybrid bonding schemes for die-to-wafer (D2W) and wafer-to-wafer (W2W) attachments, exceedingly uniform surfaces, with a low TTV and very low defectivity are required. For example, when sub-500 nm interconnects are required for backside power delivery, it is anticipated that sub-micron diameter Through Silicon Vias (TSVs) will be needed. This in turn puts practical limitations on the final RST and TTV of the thinned substrate to maintain practical aspect ratios for the TSVs when final wafer thickness is reduced to approximately 1 µm.

Conventional thinning processes require improvements if they are to meet the needs of these new applications. For example, if a wafer subjected to CMP has a TTV of 7 µm and thickness of 30 µm, but the target TTV is 1 µm for a wafer with RST of 5 µm, then substantial changes in the relative thickness uniformity and thickness of the substrate are required. Currently, such changes in the relative thickness uniformity of the substrate are not achievable by grinding and CMP, either alone or in combination. Therefore, there is need for a process for reducing the surface roughness of a surface of a substrate that can achieve these low target TTV and RST values.

Variability of non-uniformity in TTV and RST from grinding and CMP tools is also a practical consideration, as the consumables in these systems change over time and therefore the resultant profile of a substrate subjected to these thinning methods will vary over time. Any subsequent smoothing step will therefore need to take account of these variations.

What is therefore required is a smoothing process which can provide precise control of RST and thickness variation for surfaces of substrates which exhibit incoming non-uniformity from thinning processes which is substantially greater than would be acceptable for the target average substrate thickness.

### Statement of Invention

The present invention, in at least some of its embodiments, seeks to address at least some of the above described problems, desires and needs.

According to a first aspect of the invention there is provided an apparatus for thinning and reducing the surface roughness of a substrate, the apparatus comprising:
a plasma chamber;
a plasma generation device for sustaining a plasma within the plasma chamber;
a substrate support disposed within the plasma chamber for supporting the substrate;
at least one gas inlet for introducing a gas or gas mixture into the plasma chamber;
at least one plasma controlling structure configured to control the distribution of the plasma within the plasma chamber; and
a controller,
wherein the controller is configured to:
   - generate a plasma within the plasma chamber from the gas or gas mixture;
   - receive a measured variation in thickness of a substrate, a measured average substrate thickness a target variation in thickness of the substrate and a target average substrate thickness;
   - generate a generated etch routine that will provide the target variation in thickness of the substrate and a target average substrate thickness based on the measured variation in thickness and the measured average substrate thickness; and
based on the generated etch routine, control the at least one plasma controlling structure within the plasma chamber in accordance with the generated etch routine.

The present inventors have found that controlling the plasma distribution using at least one plasma controlling structure, such as a movable annular ring (typically referred to as a uniformity ring), has the most significant effect on the radial distribution of the plasma generated within the plasma chamber out of any of the most frequently adjusted etch parameters. This means that a controller configured to control the at least one plasma controlling structure within the plasma chamber in accordance with a generated etch routine whilst a plasma is generated within the plasma chamber will be able to provide an unprecedented level of control over the etching of the substrate, which can account for existing thickness variation of the substrate and provide precise control of average substrate thickness and substrate thickness variation.

The controller can be configured to control at least one of a position, orientation, or configuration of the at least one plasma controlling structure in order to control the distribution of the plasma within the plasma chamber.

The at least one plasma controlling structure can comprise at least one annular ring structure. The at least one annular ring structure can be movable along an axis perpendicular to the substrate support. The at least one annular ring structure can comprises a uniformity ring. The annular ring structure can comprise a wafer edge protection (WEP) structure. The at least one annular ring structure can comprise a combination of one or more uniformity rings and a WEP structure.

The substrate support can comprise an electrically conductive structure. The substrate support can comprise a dielectric electrostatic chuck (ESC). Alternatively, the substrate support can comprise a metallic platen. The substrate support is configured to be provided with an RF electrical signal having an RF bias power from a suitable power supply. The RF bias power may have a frequency of between 2 and 20 MHz, preferably 13.56 MHz.

The plasma generation device can be an inductively coupled plasma generation device. The controller can be configured to control the operation of at least one of the at least one gas inlet, plasma generation device, substrate support and power supply.

According to a second aspect of the invention, there is provided a method of thinning and reducing the surface roughness of a substrate, the method comprising the steps of:
- measuring a variation in thickness of a substrate and an average substrate thickness to provide a measured variation in thickness of the substrate and a measured average substrate thickness;
- defining a target variation in thickness of the substrate and a target average substrate thickness;
- generating a generated etch routine, wherein the generated etch routine is configured to etch a generated etch profile incident on the substrate to achieve the target variation in thickness of the substrate and the target average substrate thickness;
- loading the substrate into a plasma chamber of a plasma etching apparatus and locating the substrate on a substrate support;
- introducing a gas or gas mixture into the plasma chamber through at least one gas inlet;
- generating a plasma in the plasma chamber from the gas or gas mixture using a plasma generation device; and
- controlling the plasma in the plasma chamber using a controller to cause the substrate to be etched in accordance with the generated etch routine to produce a smoothed substrate,
wherein the step of controlling the plasma in the plasma chamber using a controller comprises the controller controlling at least one plasma controlling structure within the plasma chamber in accordance with the generated etch routine in order to achieve the target variation in thickness of the substrate and the target average substrate thickness, wherein the at least one plasma controlling structure is configured to control the distribution of the plasma within the plasma chamber.

The present inventors have found that, by generating a generated etch routine that takes into account not only the target variation in thickness of a substrate and target average substrate thickness, but also the existing variation in thickness of the substrate prior to plasma etching, and controlling at least one plasma controlling structure within the plasma chamber in accordance with the generated etch routine, the substrate may be etched in a manner which significantly increases the uniformity of the etched substrate over known methods whilst providing a high degree of precision over the final average substrate thickness and uniformity.

The portion of the substrate that is etched by the plasma generated in the plasma chamber is preferably not covered by a mask layer, or is otherwise unmasked. Preferably, the portion of the substrate that is etched by the plasma generated in the plasma chamber does not comprise any deposited layers or deposits on the surface of the substrate and does not have any features formed in the surface of the portion of the substrate.

The step of controlling the plasma within the plasma chamber can comprise controlling at least one of a position, orientation and configuration of the at least one plasma controlling structure. The at least one plasma controlling structure can comprise at least one annular ring structure. The at least one annular ring structure can be movable along an axis perpendicular to the substrate support. During the step of controlling the plasma in the plasma chamber using a controller, the controller can control the at least one annular ring structure to move along the axis perpendicular to the substrate support.

The at least one annular ring structure can comprise a uniformity ring. The at least one annular ring structure can comprise a wafer edge protection (WEP) structure. The substrate can be a semiconductor substrate. The semiconductor substrate can be a silicon, silicon carbide or compound semiconductor substrate. The silicon substrate can be a silicon wafer.

The measured variation in thickness of the substrate can comprise a two-dimensional representation of the surface profile of the substrate or a three-dimensional representation of the surface profile of the substrate. The measured variation in thickness of the substrate can comprise a two-dimensional representation of the surface profile of the substrate. The measured variation in thickness of the substrate can comprise a three-dimensional representation of the surface profile of the substrate.

The step of loading the substrate into the plasma chamber can be performed prior to the steps of measuring a variation in thickness of the substrate and an average substrate thickness, defining a target variation in thickness of the substrate and a target average substrate thickness and generating a generated etch routine. Alternatively, the step of loading the substrate into the chamber can be performed after any one of the steps of measuring a variation in thickness of the substrate and an average substrate thickness, defining a target variation in thickness of the substrate and a target average substrate thickness and generating a generated etch routine.

The step of generating a generated etch routine can comprise combining at least two predetermined etch routines to generate the generated etch profile, each of the at least two predetermined etch routines being configured to etch a respective predetermined etch profile incident on a substrate. Each of the at least two predetermined etch routines can be associated with a respective set of etch parameters implemented to achieve the respective predetermined etch profile. Each set of etch parameters can comprise at least one of a position, orientation and configuration of at least one plasma controlling structure within the chamber. The set of etch parameters can further comprise at least one of:
- the pressure within the chamber during the plasma etch; and/or
- the flow rate of a gas or gas mixture through the at least one gas inlet during the plasma etch; and/or
- the power supplied to the plasma generation device during the plasma etch; and/or
- the power supplied to the substrate support during the plasma etch.

The set of etch parameters can further comprise the temperature of the substrate. The set of etch parameters can further comprise the frequency of the power supplied to the plasma generation device and/or the substrate support.

The at least two predetermined etch routines can comprise a first predetermined etch routine configured to etch a first predetermined etch profile incident on a substrate and a second predetermined etch routine configured to etch a second predetermined etch profile incident on a substrate, and the generated etch routine comprises a combination of the first predetermined etch routine and the second predetermined etch routine such that a set of etch parameters associated with the generated etch routine is a combination of a first set of etch parameters associated with the first predetermined etch routine and a second set of etch parameters associated with the second predetermined etch routine. The at least two predetermined etch routines can comprise more than two predetermined etch routines, for example the at least two predetermined etch routines can comprise a first predetermined etch routine, a second predetermined etch routine and a third predetermined etch routine. The set of etch parameters associated with the generated etch routine is a combination of each of the respective set of etch parameters associated with each of the respective predetermined etch routines. In other words, in the embodiment above, the set of etch parameters associated with the generated etch routine is a combination of a first set of etch parameters associated with the first predetermined etch routine, a second set of etch parameters associated with the second predetermined etch routine and a third set of etch parameters associated with the third predetermined etch routine.

In the embodiment where the generated etch routine comprises a first etch routine and a second etch routine, the generated etch routine can comprise performing the first predetermined etch routine for a first duration, followed by performing the second predetermined etch routine for a second duration. In the embodiment where the generated etch routine comprises more than two etch routines, the generated etch routine can comprise performing each respective predetermined etch routine for a respective duration. Each respective predetermined etch routine, including the first predetermined etch routine and the second predetermined etch routine, can be performed sequentially. The second predetermined etch routine can be performed directly after the first predetermined etch routine without a break in the vacuum conditions within the chamber. Alternatively, the generated etch routine can comprise a vacuum break between the first predetermined etch routine and the second predetermined etch routine.

The step of generating a generated etch profile can comprise determining a predicted variation in thickness of the substrate following the generated etch profile and/or a predicted average substrate thickness following the generated etch profile for respective values of the first duration and the second duration, and selecting the respective values of the first duration and the second duration that correspond to the variation in thickness of the substrate following the generated etch profile and/or the predicted average substrate thickness following the generated etch profile being closest to the target variation in thickness of the substrate following the generated etch profile and/or the target average substrate thickness following the generated etch profile. The first duration and the second duration can be expressed as a ratio.

According to a third aspect of the invention, there is provided a method of reducing the thickness of a substrate, the method comprising at least one of the steps of:
a. grinding the substrate by means of relative movement between the substrate and a grinding surface to remove material from the substrate; and/or
b. removing material from the substrate by means of chemical mechanical polishing (CMP), wherein the CMP comprises contacting the substrate with a polishing pad and a CMP composition and causing relative motion between the polishing pad and the substrate while maintaining a portion of the CMP composition in contact with the substrate between the pad and the substrate,
the method further comprising reducing the surface roughness of the substrate by performing the method of the second aspect of the invention.
The method can comprise the sequential steps of grinding the substrate, removing material from the substrate by means of CMP and the method according to the second aspect of the invention.

Whilst the invention has been described above, it extends to any inventive combination of the features set out above, or in the following description, drawings or claims. For example, any features disclosed in relation to one aspect of the invention may be combined with any features disclosed in relation to any of the other aspects of the invention.

For the avoidance of doubt, whenever reference is made herein to 'comprising' or 'including' and like terms, the invention is also understood to include more limiting terms such as 'consisting' and 'consisting essentially'.

### Description of Figures

Embodiments of the invention will now be described, by way of example only, with reference to the accompanying drawings, in which:
Figure 1 is a flowchart of the steps of a method in accordance with the second aspect of the invention.
Figures 2A and 2B show representations of part of an exemplary apparatus in accordance with the first aspect of the invention;
Figure 3 shows a plot of the surface profile of an exemplary silicon wafer after CMP;
Figure 4A shows a plot of a first predetermined etch profile of a first predetermined etch routine and Figure 4B shows a plot of a simulated surface profile after performing the first predetermined etch routine on the surface profile of the wafer shown in Figure 3;
Figure 5A shows a plot of a second predetermined etch profile of a second predetermined etch routine and Figure 5B shows a plot of a simulated surface profile after performing the second predetermined etch routine on the surface profile of the wafer shown in Figure 3;
Figure 6 shows a simulated surface profile of the surface profile shown in Figure 3 after performance of the first predetermined etch routine and the second predetermined etch routine with the same amount of time on each of the first and second predetermined etch routines (1:1 ratio); and
Figure 7 shows a plot of the projected TTV of the surface profile shown in Figure 3 as a function of the ratio of the duration of the first predetermined etch routine to the duration of the second predetermined etch routine.

### Detailed Description

In the following description, examples were performed on an inductively coupled plasma (ICP)-based SPTS Rapier(RTM) XE plasma etch tool, which is commercially available from SPTS Technologies Limited of Newport, South Wales, UK. However, the methods of the present invention may be performed on alternative plasma etch tools, preferably on other ICP-based etch tools. Examples used 300 mm silicon wafers, but the methods of the invention may be applied to different substrate materials and geometries.

Where the same reference numeral has been used in different figures and/or embodiments, the feature to which it relates corresponds to a substantially identical feature.

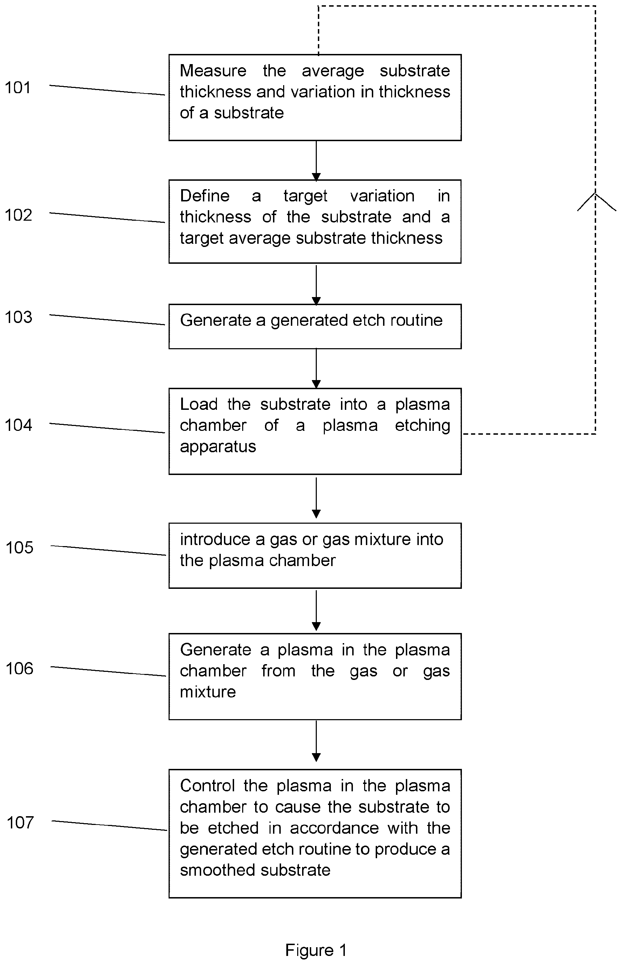

A method of thinning and reducing the surface roughness of a substrate according to an exemplary embodiment of the present invention is illustrated by the flowchart of Figure 1. The method of this embodiment is described in relation to a substrate that has been subjected to prior treatments to reduce the thickness of the substrate, such as grinding and/or Chemical Mechanical Polishing (CMP). However, the method of the exemplary embodiment may equally be applied to substrates which have not had any prior treatments to reduce the thickness of the substrate. The portion of the substrate that is to be treated using the method of the exemplary embodiment typically does not have any features formed in the surface of the substrate, or any layers such as a mask layer formed on the surface of the substrate, as it is usually the back of the substrate. Typically, the substrate material to be etched is "homogeneous", in that it does not exhibit significant variations in microstructure that would etch in different manners upon exposure to the plasma. However, the method of the exemplary embodiment of the present invention may equally be applied to "heterogeneous" substrate materials, but it would be expected that there would be a greater variation between the expected surface profile of the substrate after plasma etching and the actual surface profile obtained.

The method of the exemplary embodiment of the invention may be performed in a plasma etching apparatus comprising a plasma chamber, a substrate support for supporting the substrate within the plasma chamber, at least one gas inlet for introducing a gas or gas mixture into the plasma chamber, a plasma generation device for generating a plasma within the plasma chamber, a controller and at least one plasma controlling structure within the plasma chamber.

In a measuring step 101, the variation in thickness of the substrate and the average (mean) substrate thickness is measured to provide a measured variation in thickness of the substrate and a measured average substrate thickness. The variation in thickness is typically measured as a line scan at least across the radius of the substrate. This is likely to be sufficient in the event that the substrate is expected to demonstrate radial symmetry in its variation in thickness. However, the line scan may be performed across a greater portion of the substrate. For example, a line scan may be performed across the diameter of the substrate. This is especially useful in the event that the substrate is expected not to demonstrate radial symmetry in the variation in thickness. More than one line scan may also be performed across multiple sections of the substrate to provide a more precise measurement of the variation in thickness. The method of measurement is also not limited to a line scan, and may be performed by other methods known in the art, such as optical interferometry. The measuring step 101 may be carried out in the plasma etching apparatus by a measuring apparatus controlled by the controller, and the measured variation in thickness of the substrate and measured average substrate thickness may be stored in a memory of the controller of the plasma etching apparatus. However, the measuring step 101 may be performed by any apparatus capable of obtaining a measured variation in thickness of the substrate and a measured average substrate thickness.

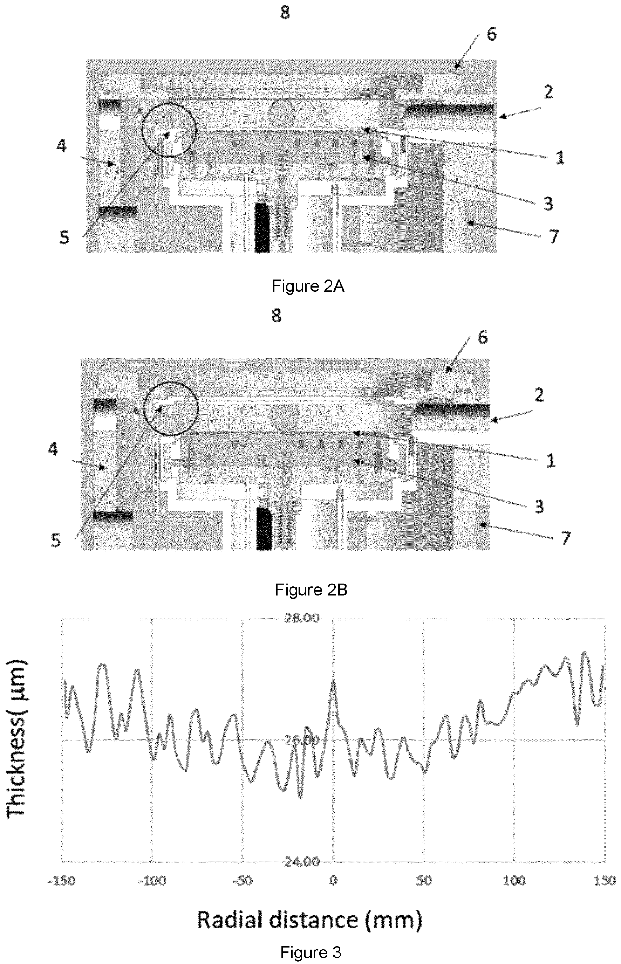

An example of the measured variation in thickness is shown in Figure 3. The variation in thickness is measured by taking a series of measurements, in this case 103 measurements, across the diameter of a 300 mm wafer. As is evident in Figure 3, the measurement of the substrate in the measuring step 101 is not limited only to the variation in thickness i.e. the local changes in the surface of the substrate, but may also measure the overall thickness of the substrate across the measured section. This allows determination of the average substrate thickness and is especially useful when attempting to significantly reduce the thickness of, or thin, the substrate, as well as attempting to reduce in the variation in thickness, or surface roughness, of the substrate. As is also evident from Figure 3, the measurement of the variation in thickness is not limited to the overall variation in thickness encapsulated by the TTV value, but also the distribution of the variation in thickness across the substrate.

In the exemplary embodiment shown in Figure 3, the substrate has been subjected to both a grinding process and a CMP process, which has resulted in a significant reduction in the average thickness of the substrate at the centre of the substrate (i.e. smaller absolute values of the radial distance) and a less significant reduction in average thickness at the periphery of the substrate (i.e. larger absolute values of the radial distance). The grinding and CMP processes have also introduced significant variation in the thickness of the substrate across the diameter of the substrate.

Once the variation in thickness of the substrate and average substrate thickness has been measured, the target variation in thickness of the substrate and a target average substrate thickness are defined in a defining step 102. The target variation in thickness of the substrate may be expressed in a number of forms. The target variation in thickness can be expressed as the Total Thickness Variation (TTV), with the expectation that a low TTV value will correspond to a low variation in thickness across the substrate. However, the target variation in thickness may also be expressed as a representation of the distribution in the variation in thickness of the substrate. This distribution could be illustrated as a two-dimensional representation or a three-dimensional representation of the surface profile of the substrate. Similarly, the target average substrate thickness may be expressed in a number of forms, but typically in the manufacture of silicon wafers, the target average substrate thickness is expressed as the Residual Silicon Thickness (RST). In the exemplary embodiment shown in Figure 3, the TTV of the substrate is 2.8 µm and the RST is 26 µm. In this exemplary embodiment, the target RST is 2.00 µm and the target TTV is 2.00 µm. Therefore, in addition to a reduction in surface roughness of the substrate (i.e. a reduction of the TTV value), a reduction in the average thickness of the substrate (i.e. a reduction in the RST) is also required.

The target variation in thickness of the substrate and the target average substrate thickness may apply across the entirety of the surface of the substrate. Alternatively, the target variation in thickness of the substrate and the target average substrate thickness may apply to a subsection of the surface of the substrate. For example, in the exemplary embodiment, the target RST and target TTV apply to the majority of the substrate, but it is desired to have a slightly thicker region at the periphery of the substrate, also known as an edge exclusion region. The edge exclusion region of a semiconductor wafer is typically not used during device fabrication. This is especially true when fabricating wafers for use in fusion-hybrid bonding, as particulate control is critical to the success of bonded dies and the edge of the wafer can be a significant source of particulate matter. The same principle may apply in the event that the wafer will be etched in an apparatus using a WEP structure, as the edge of the wafer will not be exposed to the plasma, and therefore will not be etched. In the exemplary embodiment, an edge exclusion region of approximately 2mm radial distance around the circumference of the wafer is desired. The average substrate thickness, and sometimes the variation in thickness, in this edge exclusion region can be larger than those across the remainder of the substrate. Therefore, the RST and TTV values for the entirety of the surface of the substrate will be higher than the RST and TTV values for the surface of the substrate not including this edge exclusion region. Consequently, the target variation in thickness of the substrate and the target average substrate thickness may be defined for the entirety of the substrate, for the region of the substrate not including the edge exclusion region, or even for the edge exclusion region itself.

In one embodiment, the defining step 102 may be performed in the plasma etching apparatus, and the target variation in thickness of the substrate and a target average substrate thickness may be stored in a memory of the controller.

In a generating step 103, a generated etch routine is generated in order to achieve the target variation in thickness of the substrate and the target average substrate thickness. The generated etch routine is configured to etch a generated etch profile incident on the substrate that will achieve the target variation in thickness and the target average substrate thickness. In other words, the generated etch routine, when implemented in a plasma etch apparatus, is configured to etch the substrate in a manner that will cause the substrate to have the target variation in thickness and the target average substrate thickness. This is achieved by the generated etch profile, or a measure of the predicted removal of substrate material across the surface of the substrate under the conditions within the plasma etch apparatus. This generated etch profile is achieved by careful control of the conditions within the plasma etch apparatus as part of the generated etch routine that will cause preferential plasma etching of the substrate in areas that require more substrate material to be removed to match the target average substrate thickness and target variation in thickness and cause inhibition of plasma etching of the substrate in areas that require less substrate material to be removed to match the target average substrate thickness and target variation in thickness. As a result, after etching in accordance with the generated etch routine, the substrate will have a profile with an average substrate thickness and variation in thickness approximately the same as the target values set in defining step 102 of the method.

The generated etch routine may comprise at least one predetermined etch routine, where each of the at least one predetermined etch routine is configured to etch a predetermined etch profile incident on a substrate. The predetermined etch profile may be determined from experimental data obtained from previous plasma etches. These previous plasma etches are preferably performed on similar substrates to the substrate to be treated that have standardised starting parameters to obtain the most precise illustration of the effect of the predetermined etch profile. For example, a predetermined etch profile may be obtained by plasma etching a silicon wafer that has not been thinned, which typically have a uniform thickness and a small TTV of approximately 1 µm or less. The plasma etching may be carried out using specified etch parameters, such as chamber pressure, RF power applied, gas mixture composition and gas flow rate, for a specified period of time in order to generate an etched surface. The profile of the etched surface can then be used as a predetermined etch profile for a silicon wafer under these etch conditions.

The set of etch parameters associated with each of the at least one predetermined etch routine can comprise at least one of a position, orientation and configuration of at least one plasma controlling structure within the plasma chamber. The position of the at least one plasma controlling structure may be adjusted in any manner known in the art, for example by raising and lowering the at least one plasma controlling structure relative to the substrate support or the plasma chamber in general. The orientation of the at least one plasma controlling structure may be adjusted in any manner known in the art, for example by rotating the at least one plasma controlling structure around an axis. The configuration of the at least one plasma controlling structure may be adjusted in any manner known in the art, for example by extension or retraction, or otherwise changing the dimensions, of the at least one plasma controlling structure within the plasma chamber. Changes in the position, orientation or configuration of the at least one plasma controlling structure can be brought about by any known means of controlling position, orientation or configuration. For example, the at least one plasma controlling structure may be mounted on at least one actuator, and the position of the at least one plasma controlling structure can be adjusted by the controller by extending or retracting the actuator.

The at least one predetermined etch routine may be stored in a database or other means of collating data. Once generated, the generated etch routine may also be stored in the database or other means of collating data, such that the generated etch routine can be used as a predetermined etch routine for subsequent wafer processing. The generating step 103 may be performed in the plasma etching apparatus, and the generated etch routine and associated set of etching parameters may be stored in a memory in the controller. Alternatively, the generated etch routine may be generated in a separate apparatus, and introduced into the memory of the controller for control of the etching of the substrate in a subsequent plasma etching step. In the event that the generating step 103 is performed in the plasma etching apparatus, the controller may comprise a memory that is configured to store the database or other means of collating data in which the at least one predetermined etch routine is stored. Alternatively, the database or other means of collating data in which the at least one predetermined etch routine may be stored in a separate storage medium, and introduced into the memory of the controller for control of the etching of the substrate in a subsequent plasma etching step.

The step of generating a generated etch routine can comprise combining at least two predetermined etch routines to generate the generated etch profile. Each of the at least two predetermined etch routines are configured to etch a respective predetermined etch profile incident on a substrate, such that the generated etch profile is the result of the combination of the respective predetermined etch profiles. Each of the at least two predetermined etch routines are associated with a respective set of etch parameters implemented to achieve the respective predetermined etch profile. Each set of etch parameters can comprise at least one of a position, orientation and configuration of the at least one plasma controlling structure within the plasma chamber. The set of etch parameters can further comprise at least one of the pressure within the plasma chamber during the plasma etch, the flow rate of a gas or gas mixture through the at least one gas inlet during the plasma etch, the power supplied to the plasma generation device during the plasma etch, the power supplied to the substrate support during the plasma etch, the temperature of the substrate and the frequency of the power supplied to the plasma generation device and/or the substrate support.

In one embodiment, the at least two predetermined etch routines comprise a first predetermined etch routine configured to etch a first predetermined etch profile incident on a substrate and a second predetermined etch routine configured to etch a second predetermined etch profile incident on a substrate, and the generated etch routine comprises a combination of the first predetermined etch routine and the second predetermined etch routine such that a set of etch parameters associated with the generated etch routine is a combination of a first set of etch parameters associated with the first predetermined etch routine and a second set of etch parameters associated with the second predetermined etch routine.

The combination of the first predetermined etch routine and the second predetermined etch routine can be a concurrent combination of the two routines, such that the set of etch parameters associated with the generated etch routine are an interpolation between the values of the first set of etch parameters associated with the first predetermined etch routine and the values of the second set of etch parameters associated with the second predetermined etch routine. For example, in the embodiment where the plasma controlling structure is an annular ring, the first set of etch parameters includes the annular ring being positioned at 1 cm above the substrate support and the second set of etch parameters includes the annular ring being positioned 5 cm above the substrate support, the set of etch parameters associated with the generated etch routine may include the annular ring being positioned between 1 cm and 5 cm above the substrate support

Alternatively, the combination of the first predetermined etch routine and the second predetermined etch routine in the generated etch routine may comprise performing the first predetermined etch routine for a first duration, followed by performing the second predetermined etch routine for a second duration. The first predetermined etch routine may be performed for the first duration directly before the second predetermined etch routine, such that there is no break in the vacuum conditions within the chamber between the first predetermined etch routine and the second predetermined etch routine. Alternatively, there may be a vacuum break between the first predetermined etch routine and the second predetermined etch routine.

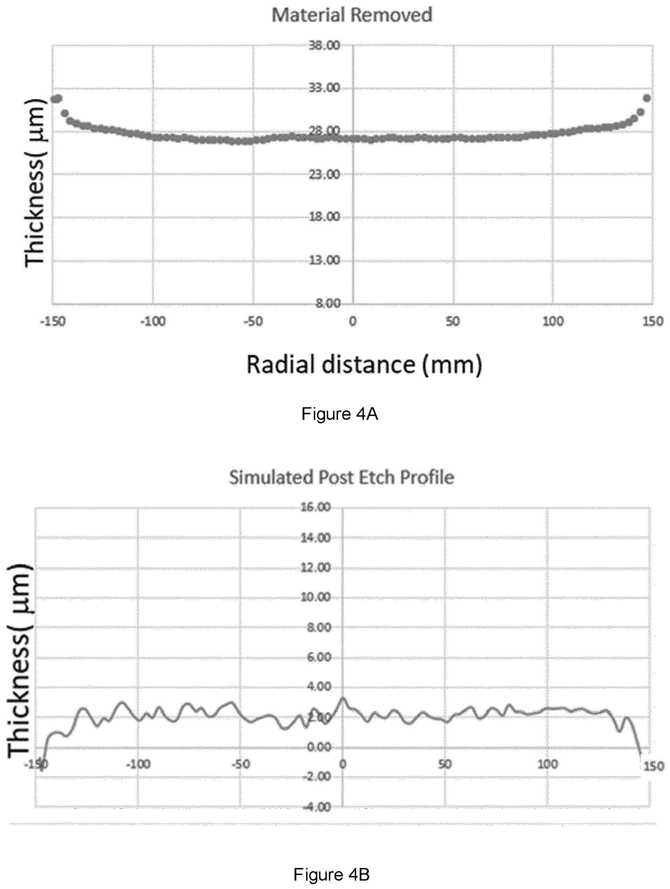

In the exemplary embodiment relating to the wafer having the profile shown in Figure 3, a first predetermined etch routine ("A routine"), having a corresponding first predetermined etch profile ("A profile") and a second predetermined etch routine ("B routine"), having a corresponding second predetermined etch profile ("B profile") were selected to generate the generated etch routine. In the A routine, the plasma controlling structure is an annular ring, and the annular ring is configured to be in a "raised" position, with the annular ring located above the surface of the substrate support. The A profile is illustrated in Figure 4A, with a corresponding plot of a simulated surface profile of the wafer after performing the A routine illustrated in Figure 4B. The predicated final average thickness is 2.04 µm, the predicted TTV for the entirety of the substrate is 2.04 µm and the predicted TTV for the 2 mm edge exclusion region at both ends of the substrate is 4.75 µm. As can be seen in Figure 4A, the A profile shows a greater removal of substrate material at the periphery of the substrate, which causes a corresponding greater reduction of the thickness of the periphery of the substrate at the periphery of the simulated surface profile in Figure 4B. In fact, in Figure 4B, the predicted rate of substrate material removal is large enough that the substrate thickness at the periphery is predicted to be negative. In practical terms, this would correspond to a complete removal of substrate material, and corresponding reduction in the radius of the substrate. This will also contribute to the predicted variance of the thickness of the substrate shown by the higher TTV value in the 2 mm edge exclusion region.

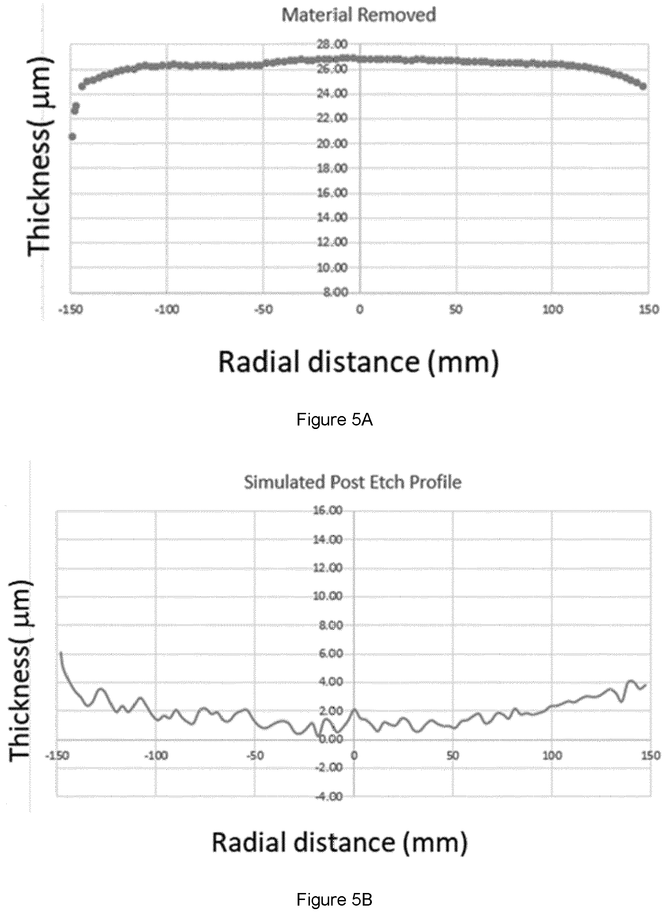

The B profile is illustrated in Figure 5A, and the corresponding plot of a simulated surface profile of the wafer after performing the B routine illustrated in Figure 5B. In the B routine, the plasma controlling structure is an annular ring, and the annular ring is configured to be in a "lowered" position, with the annular ring located on the surface of the substrate support. The predicated final average thickness is 1.95 µm, the predicted TTV for the entirety of the substrate is 1.95 µm and the predicted TTV for the 2 mm edge exclusion region at both ends of the substrate is 5.86 µm. As can be seen in Figure 5A, the B profile shows a reduced removal of substrate material at the periphery of the substrate, which causes a corresponding smaller reduction in the thickness of the periphery of the substrate at the periphery of the simulated surface profile in Figure 5B.

The generated etch profile will therefore comprise a combination of the A profile and the B profile between that illustrated in Figure 4A and Figure 5A, and would be predicted to produce a surface profile of the wafer between that illustrated in Figure 4B and that illustrated in Figure 5B.

In one embodiment, the generating step 103 of generating a generated etch profile comprises determining a predicted variation in thickness of the substrate following the generated etch profile and/or a predicted average substrate thickness following the generated etch profile for respective values of the first duration and the second duration, and selecting the respective values of the first duration and the second duration that correspond to the variation in thickness of the substrate following the generated etch profile and/or a predicted average substrate thickness following the generated etch profile being closest to the target variation in thickness of the substrate following the generated etch profile and/or the target average substrate thickness following the generated etch profile. Preferably, the generating step 103 of generating a generated etch profile comprises determining a predicted variation in thickness of the substrate following the generated etch profile and a predicted average substrate thickness following the generated etch profile for respective values of the first duration and the second duration, and selecting the respective values of the first duration and the second duration that correspond to the variation in thickness of the substrate following the generated etch profile and a predicted average substrate thickness following the generated etch profile being closest to the target variation in thickness of the substrate following the generated etch profile and the target average substrate thickness following the generated etch profile. The first duration and the second duration can be expressed as a duration ratio, and the selection process can comprise determining a predicted variation in thickness of the substrate and a predicted average substrate thickness following the etch profile for multiple values of the duration ratio and selecting the duration ratio that corresponds to the predicted variation in thickness of the substrate and the predicted average substrate thickness following the etch profile that most closely match the target variation in thickness of the substrate and target average substrate thickness set in the determining step 102.

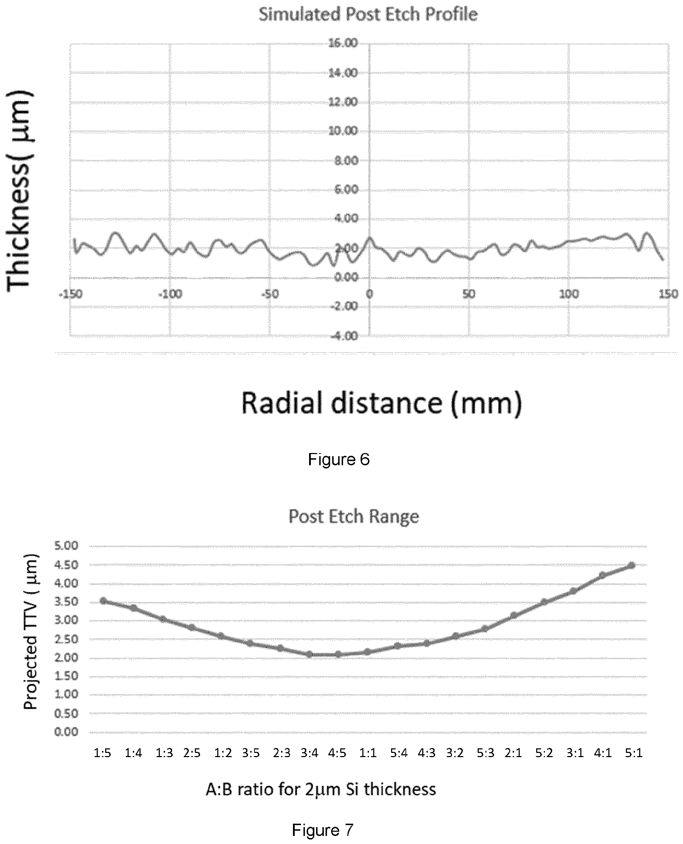

For example, in the exemplary embodiment relating to the wafer having the profile shown in Figure 3, a 1:1 ratio of the A routine, corresponding to Figures 4A and 4B, and the B routine, corresponding to Figures 5A and 5B, is predicted to produce a surface profile of the substrate as illustrated in Figure 6. This corresponds to the substrate being etched under the A routine for a first duration and subsequently etched under the B routine for a second duration, and the first and second durations being equal. The predicted surface profile has a predicted average substrate thickness of 2.00 µm and a predicted TTV of 2.15 µm. Whilst this matches the target average substrate thickness, the predicted TTV is larger than the target TTV of 2.00 µm.

A series of predicted TTV values for different duration ratios of the first predetermined profile and the second predetermined profile are illustrated in Figure 7. As can be seen in Figure 7, the lowest TTV value is obtained at a duration ratio of 4:5, that is the second duration is 1.25 times longer than the first duration. In this scenario, the predicted average substrate thickness is 2.00 µm and the predicted TTV is 2.08 µm. This is closer to the target variation in substrate thickness, and so the duration ratio of 4:5 would be selected in preference to the duration ratio of 1:1.

In the event that the generating step 103 is performed in the plasma etching apparatus, the controller may comprise a calculating unit configured to determine a predicted variation in thickness of the substrate following the generated etch profile and/or a predicted average substrate thickness following the generated etch profile for respective values of the first duration and the second duration, and select the respective values of the first duration and the second duration that correspond to the variation in thickness of the substrate following the generated etch profile and/or a predicted average substrate thickness following the generated etch profile being closest to the target variation in thickness of the substrate following the generated etch profile and/or the target average substrate thickness following the generated etch profile.

After the generating step 103, the substrate is loaded into the plasma chamber of the plasma etching apparatus and located on the substrate support in a loading step 104. However, if at least one of the measuring step 101, defining step 102 or generating step 103 are carried out in the plasma etching apparatus, then loading step 104 may be carried out prior to any of the measuring step 101, defining step 102 or generating step 103. In a preferred embodiment, the loading step 104 is carried out prior to all of the measuring step 101, defining step 102 and generating step 103, and each of the measuring step 101, defining step 102 and generating step 103 are carried out in the plasma etching apparatus. Given the substrate may be significantly reduced in thickness to the order of 1 µm, the substrate is preferably mounted on a carrier wafer or other carrier, for example a carrier wafer formed of silicon or glass, in order to facilitate handling of the substrate. The substrate may be adhered to the carrier wafer or other carrier by adhesive in order to secure the substrate.

Once the measuring step 101, defining step 102, generating step 103 and loading step 104 have been performed, regardless of the order in which they are performed, a gas or gas mixture is introduced into the plasma chamber through at least one gas inlet in a gas introducing step 105. The introduced gas or gas mixture is then ignited in a generating step 106 by the plasma generation device.

Once the plasma has been generated, the controller controls the plasma in the plasma chamber to cause the substrate to be etched in accordance with the generated etch routine to produce a smoothed substrate in a controlling step 107. In the controlling step 107, the controller controls the at least one plasma controlling structure within the plasma chamber in accordance with the generated etch routine in order to achieve the target variation in thickness of the substrate and the target average substrate thickness, wherein the at least one plasma controlling structure is configured to control the distribution of the plasma within the plasma chamber. The plasma controlling structure may be any physical component at least partially within the plasma chamber that interacts with the generated plasma in a manner to change the etch profile of the plasma on the substrate. For example, the plasma controlling structure may comprise at least one annular ring structure, which may comprise a uniformity ring and/or a WEP structure, that may be movable along an axis perpendicular to the substrate support. In this case, the controlling step 107 may comprise moving the at least one annular ring structure along the axis perpendicular to the substrate support in accordance with the generated etch routine. In the exemplary embodiment, the controller would be configured to move the annular ring between the "raised" and "lowered" positions, corresponding to the A profile and B profile, whilst performing the generated etch profile. Whilst the at least one plasma controlling structure has been primarily described herein as a plasma controlling structure which may have its position, orientation or configuration altered in order to control the plasma distribution, the at least one plasma controlling structure is not limited to this embodiment. For example, the at least one plasma controlling structure may comprise a static conductive grid within the plasma chamber or a component that is configured to impose a magnetic and/or electrical field inside the plasma chamber, such as a stationary ring within the plasma chamber which is activated by a bias voltage, an electromagnet or any other component that is known to alter plasma distribution in a controllable manner between the plasma source and the wafer surface. Each of these plasma controlling structures may be present individually or in combination to allow the control of the plasma distribution in accordance with the generated etch routine to achieve the target variation in thickness of the substrate and the target average substrate thickness.

During the controlling step 107, the average thickness of the substrate and variation in thickness can be monitored using known measurement techniques. For example, a Near Infra-Red (NIR) interferometer could be used to measure the average thickness of the substrate and variation in thickness during the etching process or at the end of the etching process to confirm the process is running as expected.

Once the generated etch profile has been performed and the target average substrate thickness and target variation in substrate thickness have been achieved, the plasma etching process will be stopped and the smoothed and thinned substrate may then be removed from the plasma etch apparatus (step 108).

The method of the second aspect of the invention can provide a much greater degree of control over the surface profile of the substrate, and provide uniform substrate surfaces, even when starting with substrates with a high degree of surface roughness. This control is provided through the generation of a tailored generated etch profile, taking into account the initial surface of the substrate, and fine control of the etching environment within the plasma by control of at least one plasma controlling structure to influence the behaviour of the plasma and therefore the resultant etch profile.

The method of the second aspect of the invention may be performed on its own on an otherwise untreated substrate, or may be performed as part of an overall method of reducing the thickness of a substrate, as recited in the third aspect of the invention. In the third aspect of the invention, the method of the second aspect of the invention may be performed after at least one of grinding the substrate by means of relative movement between the substrate and a grinding surface to remove material from the substrate and/or removing material from the substrate by means of CMP, wherein the CMP comprises contacting the substrate with a polishing pad and a CMP composition and causing relative motion between the polishing pad and the substrate while maintaining a portion of the CMP composition in contact with the substrate between the pad and the substrate. In one embodiment, both grinding and CMP may be performed on the substrate prior to the method of the second aspect of the invention. In the third aspect of the invention, the method of the second aspect of the invention is used to reduce roughness introduced during the grinding and/or CMP steps, as well as surface roughness that was initially present, to a target value and to reduce the average substrate thickness down to a target value. This can provide a much greater degree of control over the surface profile of the substrate, and provide uniform substrate surfaces, even when starting with substrates with a high degree of surface roughness.

Figure 2A shows a section of the lower plasma chamber assembly 7 of a plasma etching apparatus according to an exemplary embodiment of the invention. The plasma etching apparatus comprises a plasma chamber, at least one gas inlet for introducing a gas or gas mixture into the plasma chamber and a plasma generation device, in this case a dual concentric ICP plasma source. During operation, the substrate to be thinned 1, or wafer, is loaded through slot 2 and is placed onto substrate support 3, which in this embodiment is an electrostatic chuck (ESC). The plasma chamber is evacuated through opening 4. A plasma controlling structure 5, is located within the plasma chamber. In this embodiment, the plasma controlling structure is an annular ring structure comprising an annular ring, sometimes known as a uniformity ring. Annular ring 5 is positioned around the wafer 1 and can be raised and lowered automatically from the surface of the ESC. Annular ring 5 surrounds the wafer 1 and is movable along an axis perpendicular to the ESC. The dual concentric ICP plasma source (not shown) is located above ceramic interface plate 6. In Figure 2A, the annular ring 5 is located on the ESC. In Figure 2B, the maximum travel of the annular ring 5 is shown, with annular ring 5 in close proximity with the interface plate 6. Adjustment of the position of the annular ring 5 is provided by actuators controlled by a controller (not shown). The controller is configured to control the position of the annular ring 5 during a plasma etch of the substrate in accordance with a generated etch routine. In order to generate the generated etch routine, the controller is configured to receive a measured variation in thickness of a substrate, a measured average substrate thickness, a target variation in thickness of the substrate and a target average substrate thickness and thereby generate the generated etch routine from these data that will provide the target variation in thickness of the substrate and a target average substrate thickness based on the measured variation in thickness and measured average substrate thickness. The generated etch routine may be generated in the manner discussed above with regard to the exemplary method of the invention.

The controller is also configured to control the at least one gas inlet, dual concentric ICP plasma source and ESC in a manner known in the art. An RF electrical signal having an RF power can be supplied to the substrate support by a power supply (not shown). This RF electrical signal can also be controlled by the controller.

Once the wafer 1 is loaded within the plasma chamber, and the controller has generated or received the generated etch routine, a gas or gas mixture will be introduced into the plasma chamber through the at least one gas inlet, and a plasma will be generated by the dual concentric ICP source from the gas or gas mixture to etch the wafer in accordance with the generated etch routine.

Some etching applications require a WEP structure, either instead of or in addition to a uniformity ring, to protect an edge region of the substrate from the harsh plasma etch conditions. The WEP structure covers an edge region of the substrate without contacting the substrate to shield the edge region from the plasma. For example, the WEP structure can have an inner diameter of about 297 mm (i.e. 3 mm smaller than the diameter of a 300 mm wafer). In this example, the WEP structure will cover about a 1.5 mm wide edge region around the perimeter of the wafer. The WEP structure can also be movable along an axis perpendicular to the ESC, and adjustment of the position of the WEP structure can be provided by actuators controlled by the controller.

The annular ring structure can be made from a dielectric material, such as a ceramic material. In one embodiment, the annular ring structure can comprise a uniformity ring stacked on top of a WEP structure. However, in other embodiments, the annular ring structure can be a uniformity ring or a WEP structure. The annular ring structure can cover an edge region of the substrate, and can be spaced apart therefrom, so as to protect the edge region of the substrate from the plasma conditions during an etch process.

The annular ring structure can have a frontside surface which faces towards (and is typically exposed to) the plasma during a plasma etch process. In the illustrated embodiment, the frontside surface is the surface of the annular ring 5 that faces towards the plasma during a plasma etch process. The frontside surface can be formed in any particular shape. The annular ring structure can also comprise a backside surface which faces away from the plasma during a plasma etch process. In the embodiment of Figure 2A, the backside surface of the annular ring 5 is partially in contact with the surface of the ESC 3 that supports the wafer 1.

## Claims

1. An apparatus for thinning and reducing the surface roughness of a substrate, the apparatus comprising:
a plasma chamber;
a plasma generation device for sustaining a plasma within the plasma chamber;
a substrate support disposed within the plasma chamber for supporting the substrate;
at least one gas inlet for introducing a gas or gas mixture into the plasma chamber;
at least one plasma controlling structure configured to control the distribution of the plasma within the plasma chamber; and
a controller,
wherein the controller is configured to:
• generate a plasma within the plasma chamber from the gas or gas mixture;
• receive a measured variation in thickness of a substrate, a measured average substrate thickness a target variation in thickness of the substrate and a target average substrate thickness;
• generate a generated etch routine that will provide the target variation in thickness of the substrate and a target average substrate thickness based on the measured variation in thickness and the measured average substrate thickness; and
• based on the generated etch routine, control at least one plasma controlling structure within the plasma chamber in accordance with the generated etch routine.

2. An apparatus according to claim 1, wherein the controller is configured to control at least one of a position, orientation, or configuration of the at least one plasma controlling structure in order to control the distribution of the plasma within the plasma chamber.

3. An apparatus according to claim 1 or claim 2, wherein the at least one plasma controlling structure comprises at least one annular ring structure, optionally wherein: i) the at least one annular ring structure is movable along an axis perpendicular to the substrate support; and/or ii) the at least one annular ring structure comprises a uniformity ring; and/or iii) the at least one annular ring structure comprises a wafer edge protection (WEP) structure.

4. An apparatus according to any one of claims 1 to 3, wherein: i) the substrate support comprises an electrostatic chuck (ESC); and/or ii) the plasma generation device is an inductively coupled plasma generation device.

5. A method of thinning and reducing the surface roughness of a substrate, the method comprising the steps of:
• measuring a variation in thickness of a substrate and an average substrate thickness to provide a measured variation in thickness of the substrate and a measured average substrate thickness;
• defining a target variation in thickness of the substrate and a target average substrate thickness;
• generating a generated etch routine, wherein the generated etch routine is configured to etch a generated etch profile incident on the substrate to achieve the target variation in thickness of the substrate and the target average substrate thickness;
• loading the substrate into a plasma chamber of a plasma etching apparatus and locating the substrate on a substrate support;
• introducing a gas or gas mixture into the plasma chamber through at least one gas inlet;
• generating a plasma in the plasma chamber from the gas or gas mixture using a plasma generation device; and
• controlling the plasma in the plasma chamber using a controller to cause the substrate to be etched in accordance with the generated etch routine to produce a smoothed substrate,
wherein the step of controlling the plasma in the plasma chamber using a controller comprises the controller controlling at least one plasma controlling structure within the plasma chamber in accordance with the generated etch routine in order to achieve the target variation in thickness of the substrate and the target average substrate thickness, wherein the at least one plasma controlling structure is configured to control the distribution of the plasma within the plasma chamber.

6. A method according to claim 5, wherein the step of controlling the plasma within the plasma chamber comprises controlling at least one of a position, orientation and configuration of the at least one plasma controlling structure.

7. A method according to claim 5 or claim 6, wherein: i) the portion of the substrate that is etched by the plasma generated in the plasma chamber is not covered by a mask layer; and or ii) the substrate is a semiconductor substrate, optionally wherein the semiconductor substrate is a silicon substrate.

8. A method according to any one of claims 5 to 7, wherein the at least one plasma controlling structure comprises at least one annular ring structure, optionally wherein: i) the at least one annular ring structure is movable along an axis perpendicular to the substrate support, further optionally wherein, during the step of controlling the plasma in the plasma chamber using a controller, the controller controls the at least one annular ring structure to move along the axis perpendicular to the substrate support; and/or ii) the at least one annular ring structure comprises a uniformity ring and/or iii) the at least one annular ring structure comprises a wafer edge protection (WEP) structure.

9. A method according to any one of claims 5 to 8, wherein: i) the measured variation in thickness of the substrate comprises a two-dimensional representation of the surface profile of the substrate or a three-dimensional representation of the surface profile of the substrate; and/or ii) the step of loading the substrate into the plasma chamber is performed prior to the steps of measuring a variation in thickness of the substrate and an average substrate thickness, defining a target variation in thickness of the substrate and a target substrate thickness and generating a generated etch routine.

10. A method according to any one of claims 5 to 9, wherein the step of generating a generated etch routine comprises combining at least two predetermined etch routines to generate the generated etch profile, each of the at least two predetermined etch routines being configured to etch a respective predetermined etch profile incident on a substrate.

11. A method according to claim 10, wherein each of the at least two predetermined etch routines are associated with a respective set of etch parameters implemented to achieve the respective predetermined etch profile, optionally wherein : i) each set of etch parameters comprises at least one of a position, orientation and configuration of at least one plasma controlling structure within the plasma chamber; and/or ii) the set of etch parameters comprises at least one of:
• the pressure within the plasma chamber during the plasma etch; and/or
• the flow rate of a gas or gas mixture through the at least one gas inlet during the plasma etch; and/or
• the power supplied to the plasma generation device during the plasma etch; and/or
• the power supplied to the substrate support during the plasma etch.

12. A method according to claim 11, wherein the at least two predetermined etch routines comprise a first predetermined etch routine configured to etch a first predetermined etch profile incident on a substrate and a second predetermined etch routine configured to etch a second predetermined etch profile incident on a substrate, and the generated etch routine comprises a combination of the first predetermined etch routine and the second predetermined etch routine such that a set of etch parameters associated with the generated etch routine is a combination of a first set of etch parameters associated with the first predetermined etch routine and a second set of etch parameters associated with the second predetermined etch routine.

13. A method according to claim 12, wherein the generated etch routine comprises performing the first predetermined etch routine for a first duration, followed by performing the second predetermined etch routine for a second duration, optionally wherein: i) the step of generating a generated etch profile comprises determining a predicted variation in thickness of the substrate following the generated etch profile and/or a predicted average substrate thickness following the generated etch profile for respective values of the first duration and the second duration, and selecting the respective values of the first duration and the second duration that correspond to the variation in thickness of the substrate following the generated etch profile and/or a predicted average substrate thickness following the generated etch profile being closest to the target variation in thickness of the substrate following the generated etch profile and/or the target average substrate thickness following the generated etch profile; and/or ii) the generated etch routine comprises a vacuum break between the first predetermined etch routine and the second predetermined etch routine.

14. A method of reducing the thickness of a substrate, the method comprising at least one of the steps of:
a. grinding the substrate by means of relative movement between the substrate and a grinding surface to remove material from the substrate; and/or
b. removing material from the substrate by means of chemical mechanical polishing (CMP), wherein the CMP comprises contacting the substrate with a polishing pad and a CMP composition and causing relative motion between the polishing pad and the substrate while maintaining a portion of the CMP composition in contact with the substrate between the pad and the substrate,
the method further comprising reducing the surface roughness of the substrate by performing the method of any one of claims 5 to 13.

15. A method according to claim 14, wherein the method comprises the sequential steps of grinding the substrate, removing material from the substrate by means of CMP and the method according to any one of claims 5 to 13.
